# DEMANDE DE BREVET EUROPEEN

(11) **EP 3 772 093 A1**
(43) Date de publication de la demande: **03.02.2021**
(21) Numéro de dépôt: 20186529.2
(22) Date de dépôt: 17.07.2020
(51) Int. Cl.: H01L 21/8234, H01L 27/088, H01L 29/78, H01L 29/66

(54) **PROCÉDÉ DE FABRICATION COMPRENANT UNE DÉFINITION D'UNE LONGUEUR EFFECTIVE DE CANAL DE TRANSISTORS MOSFET**

(30) Priorité: 31.07.2019 FR 1908778
(71) Demandeur: STMicroelectronics (Rousset) SAS, 13790 Rousset (FR)
(72) Inventeur: DELALLEAU, Julien, 13015 MARSEILLE (FR); JULIEN, Franck, 13821 LA PENNE SUR HUVEAUNE (FR)
(74) Mandataire: Casalonga

(57) **Abrégé**

Le procédé de fabrication de transistors du type à effet de champ à grille métal-oxyde « MOSFET », comprend une étape d'implantation de régions de drains faiblement dopées et une étape de formation de régions de grilles ayant une longueur physique de grille (Lgate) associée à une longueur de canal de référence. L'étape d'implantation de régions de drain faiblement dopées est exécutée avant l'étape de formation de régions de grilles, et comprend une formation d'un masque d'implantation définissant les régions de drains faiblement dopées et une longueur effective de canal (Leff) de chaque transistor MOSFET, la formation du masque d'implantation étant configurée pour définir une longueur effective de canal (Leff) d'au moins un transistor MOSFET différente de la longueur de canal de référence respective.

## Description

Des modes de mise en œuvre concernent les procédés de fabrication de circuits intégrés, en particulier la définition d'une longueur effective de canal dans la fabrication de transistors à effet de champ à grille métal-oxyde MOSFET.

La fabrication des transistors à effet de champ à grille métal-oxyde MOSFET comprend typiquement une étape de formation d'une région de grille et une étape d'implantation de régions de drain faiblement dopées (ou « Lightly Doped Drain, LDD » en anglais).

Typiquement, la formation de la région de grille des transistors MOSFET comprend une formation d'une couche de silicium polycristallin conducteur, et une gravure lithographique de la couche de silicium polycristallin utilisant un masque. La lithographie des régions de grilles est typiquement une étape critique du procédé, notamment dans l'alignement du masque et la précision, la sélectivité et la complexité de la chimie de gravure, ainsi le coût de la formation des régions de grilles est très élevé.

L'implantation des régions de drain faiblement dopées comprend typiquement une implantation auto-alignée avec la région de grille, cette dernière faisant office de masque définissant les régions implantées.

Par conséquent, la longueur de canal effective, c'est-à-dire la distance entre les deux régions de drains légèrement dopées sous la grille, est déterminée par l'alignement des zones implantées avec la géométrie de la région de grille (en tenant compte notamment de la diffusion des dopants).

Or, la longueur effective du canal détermine des caractéristiques essentielles des transistors MOSFET, telles que la tension de seuil, le courant de fuite, ou encore la tension de claquage des transistors.

Il serait souhaitable de pouvoir adapter les procédés de fabrications des circuits intégrés pour modifier les caractéristiques des transistors MOSFET à moindre coût.

A cet égard il est proposé selon un aspect un procédé de fabrication d'au moins un premier transistor et d'au moins un deuxième transistor du type à effet de champ à grille métal-oxyde, comprenant une première étape d'implantation de régions faiblement dopées de part et d'autre de l'emplacement de futures régions de grilles et une deuxième étape de formation des régions de grilles ayant une longueur physique de grille associée à une longueur de canal de référence, la première étape étant exécutée avant la deuxième étape, la première étape comprenant une formation d'un masque d'implantation définissant les régions faiblement dopées et une longueur effective de canal de chaque transistor. Les longueurs physiques de grille dudit au moins un premier transistor et dudit au moins un deuxième transistor sont toutes égales, et les longueurs effectives de canal dudit au moins un premier transistor et dudit au moins un deuxième transistor sont différentes.

Les régions faiblement dopées de part et d'autre de la région de grille sont usuellement désignée par « régions de drain faiblement dopée », ou « Lightly Doped Drain » en anglais, indistinctement du côté de la région de grille accueillant la région de source ou la région de drain.

Ainsi, le masque d'implantation n'est pas dépendant de la région de grille et la longueur effective de canal de chaque transistor MOSFET n'est plus dépendante de la longueur physique de grille du transistor. Par conséquent, il est possible de faire varier la longueur effective de canal sans modifier l'étape de formation des régions de grilles, typiquement la plus coûteuse. Des circuits intégrés d'une même conception peuvent alors présenter des configurations différentes, par exemple l'un rapide et un autre à basse consommation, ou bien être corrigés ou adaptés à moindre coût. La réduction du coût peut aussi faciliter les fabrications de produits expérimentaux.

Selon un mode de mise en œuvre, la formation du masque d'implantation est configurée pour définir la longueur effective de canal d'au moins un premier transistor MOSFET inférieure à la longueur de canal de référence respective.

Cela permet notamment de diminuer la tension de seuil du transistor MOSFET, par exemple pour réaliser des transistors rapides.

Selon un mode de mise en œuvre, la formation du masque d'implantation est configurée pour définir la longueur effective de canal d'au moins un deuxième transistor MOSFET supérieure à la longueur de canal de référence respective.

Cela permet notamment de diminuer les courants de fuite du transistor MOSFET, par exemple pour réaliser un circuit intégré à basse consommation.

Selon un mode de mise en œuvre, la formation du masque d'implantation est configurée pour définir la longueur effective de canal d'au moins un troisième transistor MOSFET nulle ou suffisamment faible pour conférer un comportement toujours passant au troisième transistor MOSFET.

Selon un mode de mise en œuvre, la formation du masque d'implantation est configurée pour définir la longueur effective de canal d'au moins un quatrième transistor MOSFET suffisamment grande pour conférer un comportement toujours bloqué au quatrième transistor MOSFET.

Bien entendu, les termes « toujours passant » et « toujours bloqué » s'entendent relativement aux conditions d'utilisation auxquelles sont destinés le troisième et le quatrième transistor.

Ces modes de mise en œuvre sont par exemple applicables à des réalisations de leurres contre l'ingénierie inversée.

Avantageusement, lorsque la fabrication des transistors MOSFET comprend en outre une formation de régions diélectriques d'espacement sur les flancs des régions de grille, la formation du masque d'implantation peut être configurée pour définir la longueur effective de canal dudit au moins un quatrième transistor MOSFET délimitée sous les régions d'espacement.

En d'autres termes, les extrémités de la région de canal, de longueur effective suffisamment grande pour conférer un comportement toujours bloqué, sont cachées sous les régions d'espacement et sous la région de grille. Ainsi la longueur effective de canal est plus difficilement mesurable et cela forme un moyen supplémentaire contre l'ingénierie inversée.

Selon un mode de mise en œuvre dans lequel la fabrication des transistors MOSFET comprend en outre une formation d'au moins une région d'isolation latérale en contact avec la région de canal d'au moins un cinquième transistors MOSFET, la formation du masque d'implantation est configurée pour définir la longueur effective de canal dudit au moins un cinquième transistor MOSFET de façon à compenser une variation de ses caractéristiques due à des effets de bords parasites avec la région d'isolation latérale.

Typiquement, les régions d'isolation latérales sont réalisées suivant un procédé de tranchée d'isolation peu profonde (STI pour « Shallow Trench Isolation » en anglais), ou d'oxydation locale (LOCOS pour « Local Oxidation Silicon » en anglais).

Les effets de bords parasites, usuellement appelés « hump effects » en anglais, peuvent déformer les caractéristiques souhaitées, qui sont par exemple déterminées par la longueur de canal de référence associée à la longueur physique de grille. Le procédé selon ce mode de mise en œuvre permet ainsi de compenser une telle déformation.

Selon un mode de mise en œuvre, lesdits transistors MOSFET sont fabriqués sur une plaquette semiconductrice, et la formation du masque d'implantation est configurée pour définir la longueur effective de canal des transistors MOSFET de façon à compenser une variation des caractéristiques des transistors MOSFET corrélée avec la position de chaque transistor MOSFET sur la plaquette.

Le procédé selon ce mode de mise en œuvre permet ainsi de compenser la dispersion indésirable des caractéristiques des transistors, qui est fonction de la position du circuit sur la plaquette.

Selon un mode de mise en œuvre le masque d'implantation est formé en résine et par photolithographie.

Les étapes de formation d'un masque en résine sont typiquement beaucoup moins coûteuses que la formation des régions de grille, et ce mode de mise en œuvre permet de limiter les coûts du procédé.

Selon une alternative, le masque d'implantation est du type masque dur formé.

Cette alternative peut être avantageuse notamment dans le cas où le masque dur est par ailleurs déjà prévu dans le procédé global de fabrication du circuit intégré.

Selon un autre aspect, il est également prévu un dispositif semiconducteur, par exemple une plaquette de silicium ou une puce de circuit intégré, comprenant au moins un premier transistor et au moins un deuxième transistor, ledit au moins un premier transistor et ledit au moins un deuxième transistor comportant chacun une région de grille ayant une longueur physique de grille associée à une longueur de canal de référence, et une région de canal ayant une longueur effective de canal, dans lequel les longueurs physiques de grille dudit au moins un premier transistor et dudit au moins un deuxième transistor sont toutes égales, et les longueurs effectives de canal dudit au moins un premier transistor et dudit au moins un deuxième transistor sont différentes.

Par exemple, les longueurs effectives de canal dudit au moins un premier transistor et dudit au moins un deuxième transistor sont distinctement configurées pour :
- être égales à la longueur de canal de référence ; ou
- être suffisamment faible pour conférer un comportement toujours passant au transistor ; ou
- être suffisamment grande pour conférer un comportement toujours bloqué au transistor ; ou
- compenser une variation des caractéristiques du transistor due à des effets de bords parasites avec une région d'isolation latérale en contact avec la région de canal du transistor ; ou
- compenser une variation des caractéristiques du transistor corrélée avec la position du transistor sur une plaquette semiconductrice incorporant le dispositif semiconducteur.

D'autres avantages et caractéristiques de l'invention apparaîtront à l'examen de la description détaillée de mode de mise en œuvre, nullement limitatifs, et des dessins annexés sur lesquels :
[Fig 1]
[Fig 2]
[Fig 3]
[Fig 4]
[Fig 5]

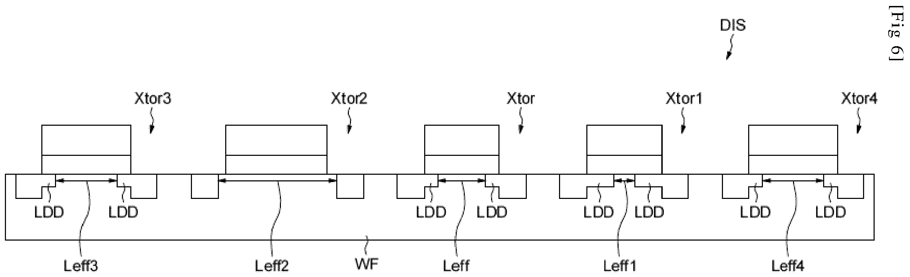

[Fig 6] illustrent des modes de mise en œuvre de l'invention.

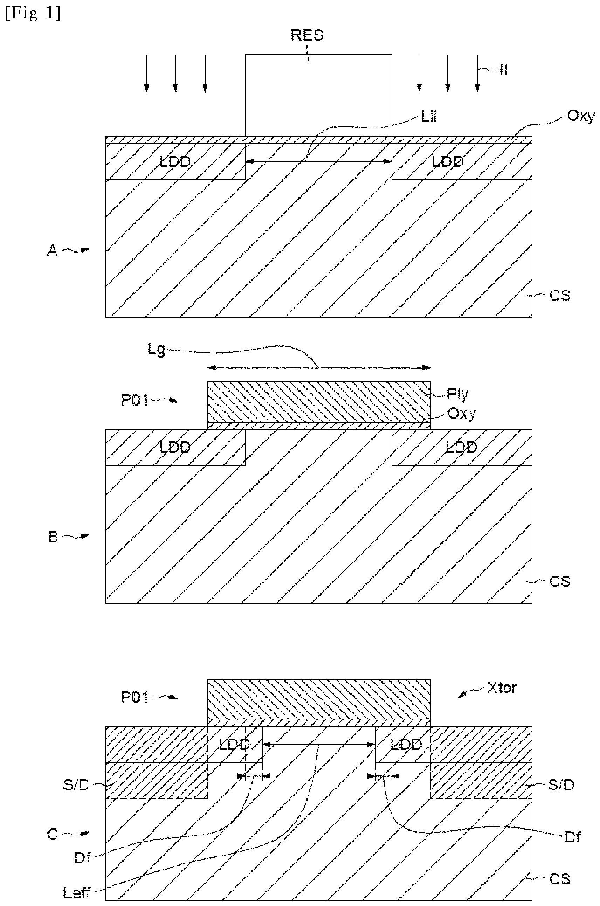

La figure 1 représente un exemple de mode de mise en œuvre d'un procédé de fabrication d'un transistor MOSFET, référencé Xtor, c'est-à-dire un transistor à effet de champ à grille métal-oxyde.

La fabrication du transistor MOSFET comprend une première étape A d'implantation de régions faiblement dopées LDD de part et d'autre d'une future région de grille PO1, mais exécutée avant une deuxième étape B de formation de régions de grilles PO1. Le transistor Xtor est formé avec une longueur de canal effective Leff, à l'issue d'une étape C de diffusion Df et d'implantation de régions de régions de conduction S/D.

Les régions faiblement dopées de part et d'autre de la région de grille sont configurées pour former des régions usuellement dites région de drain faiblement dopées, « Lightly Doped Drain » en anglais.

Les régions de drain faiblement dopée LDD sont utilisées pour élargir la zone de déplétion à la jonction drain-canal afin d'y réduire le champ électrique pour éviter des phénomènes d'injection d'électrons chauds. Pour des raisons de simplification de procédé, les côtés des régions de source sont également implantés par des régions de drains faiblement dopées LDD.

L'étape A d'implantation des régions de drains faiblement dopées LDD comprend une formation d'un masque d'implantation RES définissant les régions d'un caisson CS semiconducteur exposées à l'implantation II de particules ioniques dopantes.

Le caisson CS peut être de toute nature, par exemple du type caisson haute tension ou basse tension, de conductivité P ou N, et éventuellement un caisson natif, c'est-à-dire le substrat semiconducteur directement.

Dans l'exemple représenté, le caisson CS comporte une couche diélectrique Oxy sur sa surface, sous le masque et lors de l'implantation II de l'étape A.

Le masque d'implantation RES permet ainsi de définir la longueur Lii espaçant les régions de drains faiblement dopées LDD au moment de l'implantation II et, au terme de l'étape C, une longueur effective de canal Leff du transistor MOSFET Xtor.

En d'autres termes, le masque d'implantation RES est configuré pour définir la longueur effective de canal Leff du transistor Xtor, en tenant bien entendu compte de la diffusion des dopants.

Par exemple, le masque d'implantation RES est formé en résine photosensible par photolithographie.

En alternative, le masque d'implantation RES est du type masque dur par exemple en matériau diélectrique, préalablement déposé puis gravé suivant le model voulu. Cette alternative est avantageuse s'il est prévu une étape préalable à la formation de grille qui comprend le dépôt et la gravure des matériaux du masque dur.

Le masque dur pourrait aussi être formé par une formation préliminaire d'un matériau de grille définissant ladite longueur effective de canal Leff. La formation des régions de grilles, décrite ci-après en relation avec l'étape B, comprend alors de compléter ladite formation préliminaire après l'implantation, pour former les régions de grilles à ladite longueur physique de grille fixée. Par exemple une formation préliminaire d'une région de grille sous-dimensionnée permet de définir une longueur effective de canal plus petite, et sera ensuite complétée par une nouvelle formation d'un matériau de grille et d'une gravure à la longueur physique de grille souhaitée. Inversement, une formation préliminaire d'une région de grille sur-dimensionnée permet de définir une longueur effective de canal plus grande, et sera ensuite complétée par une gravure à la longueur physique de grille souhaitée. Cela étant cette alternative est avantageuse s'il est prévu par ailleurs dans le procédé de fabrication des étapes de dépôt préliminaire, de gravure et de nouvelles formations pour compléter les régions de grilles.

L'étape B comprend une formation de la région de grille PO1. La région de grille comprend une couche diélectrique Oxy, par exemple une couche d'oxyde de silicium, et comprend une couche conductrice Ply, par exemple un barreau de silicium polycristallin dopé conducteur. La région de grille PO1 de structure silicium polycristallin-diélectrique est usuellement dite grille métal-oxyde, historiquement.

La longueur physique Lg de la région de grille est ainsi définie à l'étape B par une gravure typiquement précise et couteuse.

En effet, la lithographie des régions de grilles est typiquement une étape critique des procédés de fabrication de transistors MOSFET, notamment en matière d'alignement du masque, et en matière de précision, de sélectivité et de complexité de la chimie de gravure, ce qui représente un coût élevé.

Par exemple le coût de la formation des régions de grilles peut être évalué à 10 fois le coût de la formation du masque RES de l'étape A.

L'étape C représente de façon simplifiée la finalisation de la fabrication du transistor MOSFET Xtor, comprenant une diffusion Df des régions de drain faiblement dopées LDD, et une formation des régions de conductions S/D, c'est-à-dire la source et le drain, du transistor Xtor.

Ainsi, le masque d'implantation RES est configuré pour définir la longueur effective de canal Leff du transistor Xtor, en tenant compte de la diffusion Df des régions de drain faiblement dopées. La définition de la longueur effective de canal Leff est par conséquent indépendante de la région de grille PO1 et de sa géométrie.

Dans les procédés de fabrication classiques, l'implantation des régions de drain faiblement dopées est effectuée après la formation de la région de grille, et la région de grille PO1 est utilisée comme masque dur définissant la position autoalignée des régions de drain faiblement dopées LDD. Ainsi, dans les procédés classiques, c'est la longueur physique de la région de grille Lg qui définit la distance entre les deux régions de drain faiblement dopées LDD. Par conséquent et en particulier, dans les procédés classiques, c'est la longueur physique de grille Lg qui définit la longueur de canal effective Leff du transistor Xtor.

Or, dans le procédé de fabrication de la figure 1, la longueur de canal effective Leff est indépendante de la longueur physique Lg de la région de grille PO1. La longueur effective de canal Leff peut ainsi être configurée de façon à être différente d'une longueur de canal de référence telle qu'elle serait définie par une implantation classique auto alignée sur la région de grille PO1.

De façon classique et connue en soi, la longueur effective de canal Leff paramètre de nombreuses caractéristiques d'une réalisation de transistor MOSFET. En particulier, la tension de seuil, la tension de claquage, le courant de fuite et le courant de saturation d'un transistor sont des caractéristiques paramétrées par la longueur effective de canal Leff.

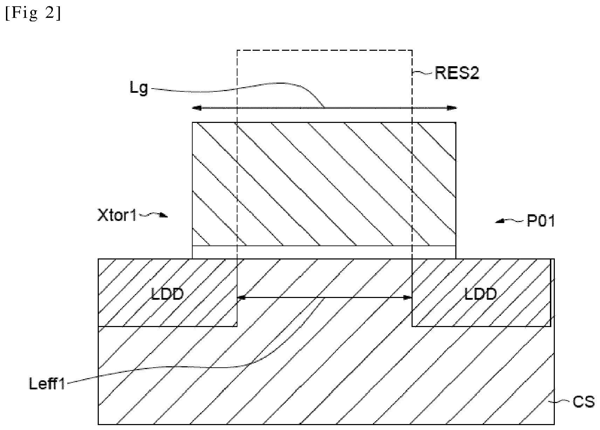

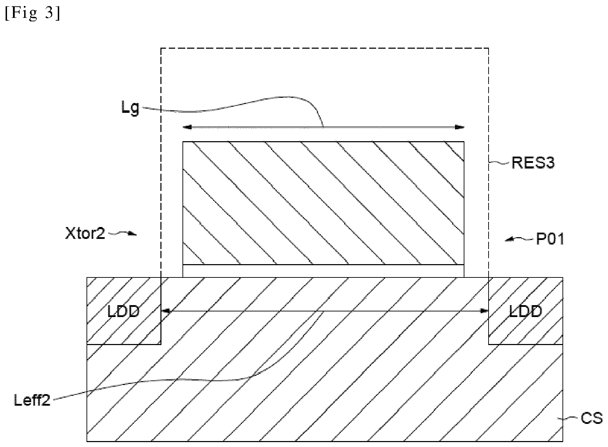

Les figures 2 et 3 illustrent des exemples dans lesquels les masques d'implantation RES1, RES2 sont configurés pour définir les longueurs effectives de canal Leff1, Leff2 de transistors Xtor1, Xtor2 différentes d'une longueur de canal de référence Lg.

Par simplification de principe, les diffusions des dopants des régions implantés ne sont pas représentées sur les figures 2 et 3, la longueur effective de canal étant alors alignée avec la formation des masques respectifs RES2, RES3, et la longueur de canal de référence étant alors assimilée à la longueur physique de grille Lg. Bien entendu, en pratique il sera dûment tenu compte des diffusions des régions de drain faiblement dopées LDD dans les caissons CS, tant pour la considération de la longueur effective de canal que pour la considération de la longueur de canal de référence.

Dans l'exemple de la figure 2, le masque d'implantation RES2 est configuré pour définir la longueur effective de canal Leff1 d'un premier transistor MOSFET Xtor1, inférieure à la longueur de canal de référence Lg.

Dans l'exemple de la figure 3, le masque d'implantation RES3 est configurée pour définir la longueur effective de canal Leff2 d'un deuxième transistor Xtor2 supérieure à la longueur de canal de référence Lg.

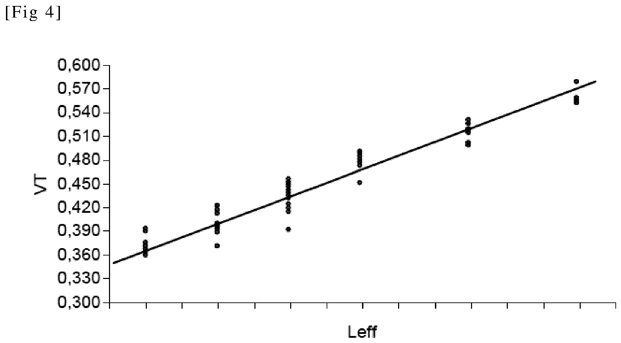

La figure 4 représente des résultats de mesures de la tension de seuil VT en fonction de la longueur effective de canal Leff de différentes réalisations de transistors MOSFET identiques, ayant notamment une même longueur physique de grille Lg, mais pour lesquelles la formation du masque d'implantation a été configurée pour définir des longueurs effectives de canal Leff différentes.

Ces mesures montrent qu'il existe une relation linéaire positive entre la longueur effective de canal Leff et la tension de seuil Vt en résultant, dans une plage de longueurs effective.

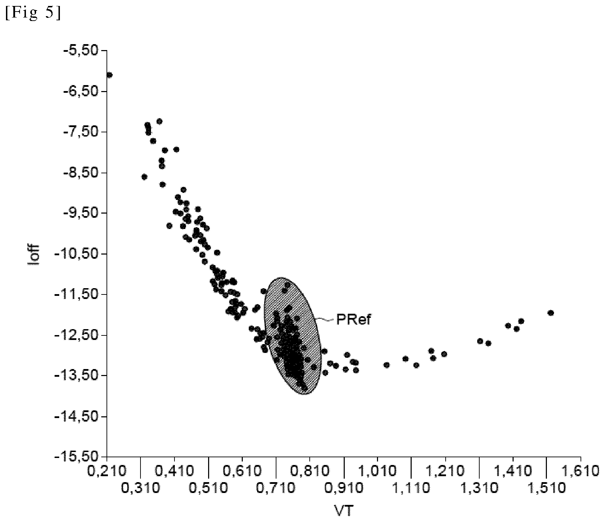

La figure 5 représente des résultats de mesures de la tension de seuil VT et du courant de fuite Ioff des différentes réalisations de transistors MOSFET identiques, ayant notamment une même longueur physique de grille Lg, mais pour lesquelles la formation du masque d'implantation a été configurée pour définir des longueurs effectives de canal Leff différentes de la figure 4.

La figure 5 est un graphique en nuage de points dont les coordonnées sont la tension de seuil mesurée VT en abscisse, et le courant de fuite mesuré Ioff en ordonnée, pour chaque réalisation.

Une population de référence PRef correspond à mesures effectuées sur des transistors de réalisation classique, ayant comme longueur effective de canal la longueur de canal de référence définie par la longueur physique de grille Lg.

Par rapport à la population de référence PRef, lorsque la tension de seuil VT est réduite, alors le courant de fuite Ioff augmente.

Lorsque la tension de seuil VT est augmentée, alors le courant de fuite Ioff reste stable, suivant néanmoins une légère augmentation.

Ainsi, il est possible de moduler la tension de seuil VT et le courant de fuite Ioff d'une réalisation d'un transistor ayant une longueur physique de grille donnée.

Ainsi, dans un procédé de fabrication prévoyant plusieurs réalisations de transistors théoriquement identiques prévoyant la même longueur physique de grille Lg, il est possible de donner une tendance différente aux caractéristiques d'au moins un transistor, et de compenser des dispersions indésirables des caractéristiques souhaitées d'au moins un transistor.

Les tendances données aux caractéristiques dudit au moins un transistor peuvent être par exemple du type plus rapide, ou moins consommateur d'énergie.

Par exemple, en se référant à nouveau à la figure 2, la longueur effective de canal Leff est plus petite que la longueur de canal de référence Lg, ainsi la tension de seuil VT de ce premier transistor est plus faible et une tendance plus rapide a été donnée au premier transistor Xtor1.

A l'inverse, en se référant désormais à la figure 3, la longueur effective de canal Leff est plus grande que la longueur de canal de référence Lg, les courants de fuites sont limités, et ainsi une tendance basse consommation a été donnée à ce deuxième transistor Xtor2.

Par ailleurs, en alternatives aux réalisations des figures 2 et 3, il est possible configurer le masque d'implantation RES2, RES3, de façon à réaliser des dispositifs de leurres contre l'ingénierie inversée.

En effet, le masque d'implantation RES2 peut éventuellement être configurée pour définir la longueur effective de canal Leff1 d'un troisième transistor Xtor1 suffisamment faible, éventuellement nulle, pour conférer un comportement toujours passant au troisième transistor Xtor1.

Bien entendu, par le terme « toujours passant », on entend que le troisième transistor est toujours passant, ou du moins présente un comportement assimilable à un état passant, dans les conditions d'utilisation auxquelles est normalement destiné le troisième transistor Xtor1.

Au contraire, le masque d'implantation RES3 peut éventuellement être configurée pour définir la longueur effective de canal Leff2 d'un quatrième transistor Xtor2 suffisamment grande pour lui conférer un comportement toujours bloqué.

De même, par le terme « toujours bloqué », on entend que le transistor est toujours bloqué, ou du moins présente un comportement assimilable à un état bloqué, dans les conditions d'utilisation auxquelles est normalement destiné le quatrième transistor Xtor2.

Dans le cas du quatrième transistor Xtor2, il est avantageux que la région de canal effective Leff2, définie entre les deux régions de drain faiblement dopées LDD, soit recouverte et cachée par une structure. Ainsi, il est avantageux de définir la longueur effective de canal Leff2 du quatrième transistor Xtor2 de façon délimitée sous des régions d'espacement, « spacer » selon le terme anglais usuel, classiquement prévues sur les flancs de la région de grille (non représentés).

Ainsi, les transistors toujours passants et toujours bloqués, par exemple incorporés dans une réalisation de portes logiques, peuvent avoir une fonction de leurre contre l'ingénierie inversée, en perturbant une analyse fonctionnelle du circuit.

Les dispersions indésirables à compenser peuvent résulter d'aléas de la nature des procédés de fabrications.

Par exemple il existe une dispersion des caractéristiques des transistors réalisés sur une même plaquette semiconductrice (« wafer » selon le terme anglais usuel) qui dépend de la localisation du transistor sur la plaquette. Il existe en effet une variation des caractéristiques des transistors fabriqués dans les régions radialement vers l'extérieur des plaquettes, par rapport aux caractéristiques des transistors fabriqués dans une région centrale des plaquettes.

Ainsi, dans le procédé décrit précédemment en relation avec les figures 1 à 3, la formation du masque d'implantation peut être configurée pour définir la longueur effective de canal Leff des transistors MOSFET de la plaquette de façon à compenser la variation des caractéristiques des transistors MOSFET corrélée avec la position de chaque transistor MOSFET sur la plaquette.

Un autre exemple de dispersion des caractéristiques des transistors résulte d'effets de bord parasites des transistors dont une bordure de la région de canal est en contact avec une région d'isolation latérale. Les régions d'isolation latérales, classiques et connues, sont presque toujours présentent dans les circuit intégré, suivant des techniques du type tranchées d'isolation peu profondes (« shallow trench isolation » selon le terme anglais usuel).

Sommairement, les effets de bords parasites sont dus à une modification de la concentration des dopants dans la région de canal causée par une migration des dopants vers la région d'isolation latérale.

De même, la formation du masque d'implantation peut être configurée pour définir la longueur effective de canal Leff des transistors au voisinage des région d'isolation latérales, de façon à compenser une variation de ses caractéristiques due aux effets de bords parasites avec la région d'isolation latérale.

La figure 6 représente un exemple de dispositif semiconducteur DIS, comportant différentes réalisations de transistors respectivement obtenues selon des modes de mise en œuvre décrits ci-avant en relation avec les figures 1 à 3.

Par exemple le dispositif semiconducteur DIS est une plaquette de silicium WF (« wafer » selon le terme anglais usuel) sur laquelle sont fabriquées plusieurs puces de circuits intégrés, mais le dispositif DIS pourrait n'être qu'une unique puce de circuit intégré.

Le dispositif semiconducteur DIS comporte un transistor Xtor dit de référence, ayant une longueur de canal de référence Leff, obtenu par le procédé décrit précédemment en relation avec la figure 1.

La longueur de canal de référence Leff correspond par exemple à la longueur effective de canal obtenue à partir de la longueur physique de grille Lg (figure1) tel que décrit précédemment en relation avec la figure 1.

Le dispositif semiconducteur DIS comporte un premier transistor Xtor1, ayant une première longueur effective de canal Leff1 plus petite que la longueur de canal de référence Leff.

Par exemple, la première longueur effective de canal Leff1 peut être suffisamment faible pour conférer un comportement toujours passant au transistor Xtor1.

Le premier transistor Xtor1 est par exemple obtenu par le procédé décrit précédemment en relation avec la figure 2.

Le dispositif semiconducteur DIS comporte un deuxième transistor Xtor2, ayant une deuxième longueur effective de canal Leff2 plus grande que la longueur de canal de référence Leff.

Par exemple, la deuxième longueur effective de canal Leff2 peut être suffisamment grande pour conférer un comportement toujours bloqué au transistor Xtor2.

Le deuxième transistor Xtor2 est par exemple obtenu par le procédé décrit précédemment en relation avec la figure 3.

Le dispositif semiconducteur DIS comporte un troisième transistor Xtor3, ayant une troisième longueur de canal Leff3 configurée pour compenser une variation de ses caractéristiques due aux effets de bords parasites avec une région d'isolation latérale à son voisinage (non visible dans le plan de la figure 6).

Par exemple, la troisième longueur effective de canal Leff3 est configurée pour que le troisième transistor Xtor3 présente les mêmes caractéristiques effectives que le transistor de référence Xtor, malgré la présence de la région d'isolation latérale à son voisinage.

Le troisième transistor Xtor3 est par exemple obtenu par le procédé tel que décrit précédemment en relation les figures 1 à 3.

Le dispositif semiconducteur DIS comporte un quatrième transistor Xtor4, ayant une quatrième longueur effective de canal Leff4 configurée pour compenser la variation des caractéristiques du quatrième transistor Xtor4 corrélée avec la position transistor sur la plaquette WF.

Par exemple, la quatrième longueur effective de canal Leff4 est configurée pour que le quatrième transistor Xtor4 présente les mêmes caractéristiques effectives que le transistor de référence Xtor, malgré les positions différentes sur la plaquette WF du transistor de référence Xtor et du quatrième transistor Xtor4.

Le quatrième transistor Xtor4 est par exemple obtenu par le procédé tel que décrit précédemment en relation les figures 1 à 3.

Le dispositif semiconducteur DIS présente l'avantage de comporter de nombreuses configurations de longueurs effectives de canal Leff, Leff1, Leff2, Leff3, Leff4 pour des transistors de même nature (c'est-à-dire ayant la même longueur physique de grille), les longueurs effectives de canal ayant été choisies de façon dédiée à chaque réalisation de transistor MOSFET et à moindre coût.

Ainsi, les caractéristiques des transistors MOSFET ont pu être adaptées de façon optimale pour chaque transistor, et les circuits intégrés équipés des puces provenant d'une telle plaquette WF seront eux aussi optimisés pour les applications auxquelles ils sont destinés.

En outre, les circuits intégrés équipés des puces provenant d'une telle plaquette WF pourront présenter une meilleure homogénéité dans leurs comportements, étant donné que des dispersions indésirables résultants d'aléas des procédés de fabrications ont été compensées.

## Revendications

1. Procédé de fabrication d'au moins un premier transistor et d'au moins un deuxième transistor du type à effet de champ à grille métal-oxyde, comprenant une première étape (A) d'implantation de régions faiblement dopées (LDD) de part et d'autre de l'emplacement de futures régions de grilles (PO1) et une deuxième étape (B) de formation des régions de grilles (PO1) ayant une longueur physique de grille (Lg) associée à une longueur de canal de référence, la première étape (A) étant exécutée avant la deuxième étape (B), la première étape (A) comprenant une formation d'un masque d'implantation (RES) définissant les régions faiblement dopées (LDD) et une longueur effective de canal (Leff, Leff1, Leff2, Leff3, Leff4) de chaque transistor (Xtor, Xtor1, Xtor2, Xtor3, Xtor4), dans lequel les longueurs physiques de grille (Lg) dudit au moins un premier transistor et dudit au moins un deuxième transistor sont toutes égales, et les longueurs effectives de canal (Leff) dudit au moins un premier transistor et dudit au moins un deuxième transistor sont différentes.

2. Procédé selon la revendication 1, dans lequel la formation du masque d'implantation (RES) est configurée pour définir la longueur effective de canal (Leff) d'au moins un premier transistor (Xtor1) inférieure à la longueur de canal de référence respective.

3. Procédé selon l'une des revendications 1 ou 2, dans lequel la formation du masque d'implantation (RES) est configurée pour définir la longueur effective de canal (Leff) d'au moins un deuxième transistor (Xtor2) supérieure à la longueur de canal de référence respective.

4. Procédé selon l'une des revendications 1 à 3, dans lequel la formation du masque d'implantation (RES) est configurée pour définir la longueur effective de canal (Leff) d'au moins un troisième transistor (Xtor1) nulle ou suffisamment faible pour conférer un comportement toujours passant au troisième transistor (Xtor1).

5. Procédé selon l'une des revendications 1 à 4, dans lequel la formation du masque d'implantation est configurée pour définir la longueur effective de canal (Leff) d'au moins un quatrième transistor MOSFET (Xtor2) suffisamment grande pour conférer un comportement toujours bloqué au quatrième transistor (Xtor2).

6. Procédé selon la revendication 5, la fabrication des transistors (Xtor) comprenant en outre une formation de régions diélectriques d'espacement sur les flancs des régions de grille (PO1), dans lequel la formation du masque d'implantation (RES) est configurée pour définir la longueur effective de canal (Leff) dudit au moins un quatrième transistor (Xtor2) délimitée sous les régions d'espacement.

7. Procédé selon l'une des revendications 1 à 6, la fabrication des transistors (Xtor) comprenant en outre une formation d'au moins une région d'isolation latérale en contact avec la région de canal d'au moins un cinquième transistor, dans lequel la formation du masque d'implantation (RES) est configurée pour définir la longueur effective de canal (Leff) dudit au moins un cinquième transistor de façon à compenser une variation de ses caractéristiques due à des effets de bords parasites avec la région d'isolation latérale.

8. Procédé selon l'une des revendications 1 à 7, lesdits transistors étant fabriqués sur une plaquette semiconductrice, dans lequel la formation du masque d'implantation (RES) est configurée pour définir la longueur effective de canal (Leff) des transistors de façon à compenser une variation des caractéristiques des transistors corrélée avec la position de chaque transistor sur la plaquette.

9. Procédé selon l'une des revendications 1 à 8, dans lequel le masque d'implantation (RES) est formé en résine et par photo lithographie.

10. Procédé selon l'une des revendications 1 à 8, dans lequel le masque d'implantation (RES) est du type masque dur.

11. Dispositif semiconducteur (DIS), comprenant au moins un premier transistor (Xtor) et au moins un deuxième transistor (Xtor1, Xtor2, Xtor3, Xtor4), ledit au moins un premier transistor et ledit au moins un deuxième transistor comportant chacun une région de grille ayant une longueur physique de grille (Lg) associée à une longueur de canal de référence, et une région de canal ayant une longueur effective de canal (Leff1, Leff2, Leff3, Leff4), dans lequel les longueurs physiques de grille (Lg) dudit au moins un premier transistor et dudit au moins un deuxième transistor sont toutes égales, et les longueurs effectives de canal (Leff) dudit au moins un premier transistor et dudit au moins un deuxième transistor sont différentes.

12. Dispositif semiconducteur selon la revendication 11, dans lequel les longueurs effectives de canal (Leff) dudit au moins un premier transistor (Xtor) et dudit au moins un deuxième transistor (Xtor1, Xtor2, Xtor3, Xtor4) sont distinctement configurées pour :
- être égales à la longueur de canal de référence ; ou
- être suffisamment faible pour conférer un comportement toujours passant au transistor (Xtor1) ; ou
- être suffisamment grande pour conférer un comportement toujours bloqué au transistor (Xtor2) ; ou
- compenser une variation des caractéristiques du transistor due à des effets de bords parasites avec une région d'isolation latérale en contact avec la région de canal du transistor (Xtor3) ; ou
- compenser une variation des caractéristiques du transistor (Xtor4) corrélée avec la position du transistor sur une plaquette semiconductrice incorporant le dispositif semiconducteur (DIS).
